# EUROPEAN PATENT SPECIFICATION

(11) **EP 1 047 129 B1**
(45) Date of publication and mention of the grant of the patent: **03.01.2007**
(21) Application number: 99830227.7
(22) Date of filing: 20.04.1999
(51) Int. Cl.: H01L 23/49

(54) **Bonding method for an integrated circuit**
Bondverfahren für eine integrierte Schaltung
Procédé pour le liaison d'un circuit intégré

(43) Date of publication of application: 25.10.2000
(73) Proprietor: STMicroelectronics S.r.l., 20041 Agrate Brianza (Milano) (IT)
(72) Inventor: Crema, Paolo, 20059 Vimercate - Milano (IT)
(74) Representative: Siniscalco, Fabio

(56) References cited:
- EP-A- 0 601 323
- GB-A- 2 248 416
- PATENT ABSTRACTS OF JAPAN vol. 011, no. 051 (E-480), 17 February 1987 (1987-02-17) & JP 61 214454 A (NIPPON MINING CO LTD), 24 September 1986 (1986-09-24)

## Description

The present invention relates to a bonding method for an integrated circuit.

Integrated circuits are formed in a chip of semiconductor material in which external electrical contacts, generally consisting of conducting pads arranged on a surface of the chip, are provided. Each pad is connected by a conducting wire to a corresponding terminal for the electrical connection of the integrated circuit to the exterior.

The wires have a rather small cross-section (of the order of 25-50 µm, for example), to provide the mechanical properties (flexibility) necessary for their use. They consequently have a high resistance to the flow of electrical current. This causes a problem, for example, in the case of integrated power circuits, which require high currents (up to several A), or in the case of special integrated circuits with low internal resistance, since it forms a bottleneck which substantially negates the advantages provided by these integrated circuits.

A known solution consists in the use of a braid consisting of a plurality of wires twisted together for connecting each pad to the corresponding terminal. This solution has the disadvantage of being rather expensive, and this is reflected in the final cost of an electronic device in which the integrated circuit is included. Moreover, one or more wires of the braid may become disconnected from the pad or from the corresponding terminal; this situation is not detectable during the normal stages of testing the electronic device, since the electrical connection between the pad and the terminal is maintained by the other wires. The reliability of the electronic device therefore becomes low, since the device is not capable of withstanding the requisite current level.

Document EP-A-0601323 describes an integrated chip having conductive site and electrical conductive leads that are interconnected by an electrically conductive wire coated with a dielectric material. In one embodiment an electrically conductive coating surrounds the dielectric coating. Both coatings are applied after connection has been made between the conductive site and the corresponding lead via the wire.

Patent Abstract of Japan 61214454 and GB-A-2248416 describe bonding wires comprising a core wire covered by a conductive layer.

The object of the present invention is to overcome the aforesaid disadvantages. To achieve this object, a bonding method for an integrated circuit as described in the first claim is proposed.

To summarize, it is proposed a bonding method for an integrated circuit formed in a chip of semiconductor material having a plurality of external electrical contacts, the method comprising the steps of providing a plurality of terminals for the electrical connection of the integrated circuit to the exterior, connecting each of a plurality of conducting wires between a contact and a corresponding terminal, and covering each conducting wire connected between the contact and the corresponding terminal with a layer of conducting material.

Further characteristics and the advantages of the bonding method according to the present invention will be made clear by the following description of a preferred embodiment of the invention, provided for guidance only and without restriction, with reference to the attached figures, in which
Fig. 1 shows an electronic device in which the method according to the present invention can be used;
Fig. 2 is an electrolytic cell used to apply this method.

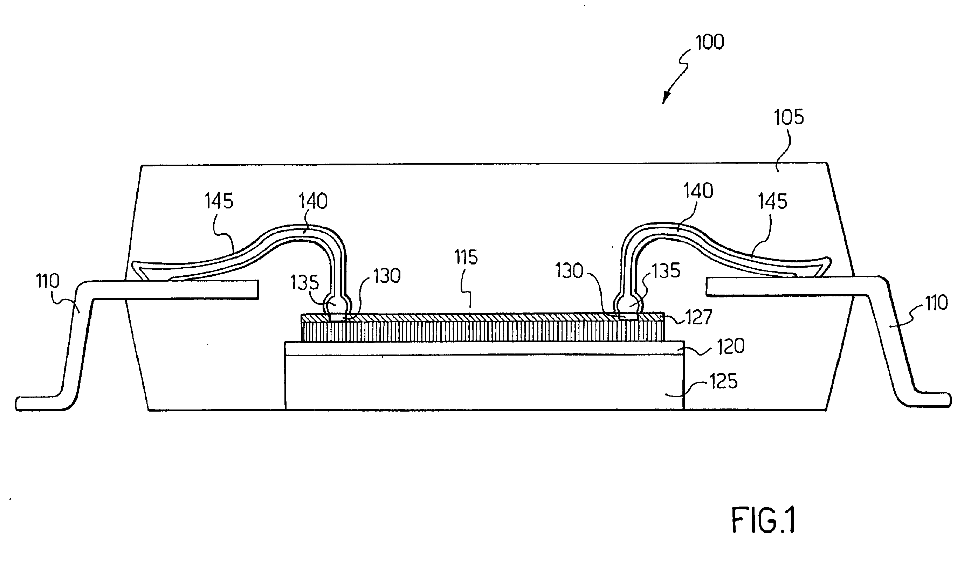

With reference to Fig. 1 in particular, an electronic power device 100, capable of operating at high current (for example from 100 mA to 10 A) and at high voltage (for example from 100 V to 1 kV) is shown. The electronic device 100 consists of an insulating casing 105, made from plastic material, from which a plurality of terminals (leads) 110 project, two of these being shown in the figure, for connection to an external circuit. In particular, the terminals 110 are bent so that their outer ends form a supporting surface for a surface mounting of the electronic device 100 on a printed circuit board (PCB) not shown in the figure.

A chip of semiconductor material 115, within which an integrated circuit is formed, is incorporated into the insulating casing 105. The chip 115 is fixed on a supporting pad 120, under which is connected a heat sink 125, whose lower surface emerges from the insulating casing 105. A plurality of conducting pads 130 (two of which are shown in the figure) are provided on an upper free surface of the chip 115, which is covered with an insulating layer 127; the conducting pads 130, typically made from aluminium, are connected electrically to the integrated circuit of the chip 115. A bump 135, made from nickel for example, is formed on each pad 130. Conducting wires 140, made from aluminium, connect each pad 130 (through the bump 135) to an inner end of the corresponding terminal 110.

A lead frame, consisting of a metal sheet in which a plurality of supporting pads 120 with the corresponding terminals 110 (joined together by interconnecting sections) is formed by punching, is used to make the electronic device 100 described above; the lead frame 110, 120 is generally made from copper, with the inner ends of the terminals 110 silver-plated (for the connection of the wires 140). The heat sinks 125 are seamed to the supporting pads 120, by means of four rivets each, for example.

Each chip 115 is soldered on to the corresponding supporting pad 120; the wires 140 are connected to the bumps 135 and to the inner ends of the terminals 110 by a thermocompression welding process. The structure formed in this way is subjected to a stage of cleaning consisting in washing in deionized water to remove dust and other residues. This is followed by a moulding process, in which the structure is mounted in a suitable mould into which a plastic material in the liquid state (for example a thermosetting epoxy resin) is injected. The polymerization of the resin (post moulding curing, or PMC) produces a system which comprises, for each electronic device 100, the insulating casing 105 which incorporates the elements described above and from which parts of the terminals 110 (and of the interconnecting sections) project. The outer ends of the terminals 110 are plated with a solder alloy (tin-lead for example), for connection to the printed circuit board. The terminals 110 (and the interconnecting sections) are cropped in such a way as to separate the different electronic devices 100, and the terminals 110 are then bent (lead forming).

Similar considerations are applicable in cases in which the electronic device is made by a different process and with other materials, is not a power device (and therefore has gold wires and no heat sink), is a device of the ball grid array (BGA) type, with its terminals formed by conducting balls arranged on a lower surface of a substrate on which the chip is fixed, is not of the surface mounting type, uses a naked chip fixed directly to the printed circuit board (and therefore has the wires connected to conducting tracks of the printed circuit board, or similar.

In the solution according to the present invention, each wire 140, when connected to the pad 130 and to the terminal 110, is covered (plated) with a layer of conducting material 145 (as described in detail below). This makes it possible to produce elements for connection between the pads 130 and the terminals 110 (each formed by a wire 140 and the corresponding conducting layer 145) having a large cross-section, up to 200-300 µm for example.

This solution considerably reduces the resistance of the connecting elements 140, 145 formed in this way; the electrical performance of the whole electronic device 100 is improved, since the connecting elements 140, 145 have a limited voltage drop, reduce any delay in the transmission of electrical signals and permit the flow of high currents. The solution according to the present invention is particularly advantageous in the case of integrated power circuits, for example for motor vehicle or high-fidelity (Hi-Fi) audio applications, or in the case of special integrated circuits with low internal resistance, although its use in different applications is not excluded.

This result is obtained in an extremely simple and economical way, without increasing the cross-section of the wires 140 and the dimensions of the pads 130. Moreover, the electronic device 100 produced in this way is particularly reliable.

Preferably, the conducting layers 145 are made from a material different from that of the wires 140 (aluminium or gold), although the use of the same material is not excluded. In a particularly advantageous embodiment of the present invention, the conducting layers 145 are made from copper. This material has a conductivity greater than that of aluminium and gold which are typically used for making the wires 140 because of their mechanical properties (ductility); additionally, this makes it possible to contain the costs of the material required to make the connecting elements 140, 145.

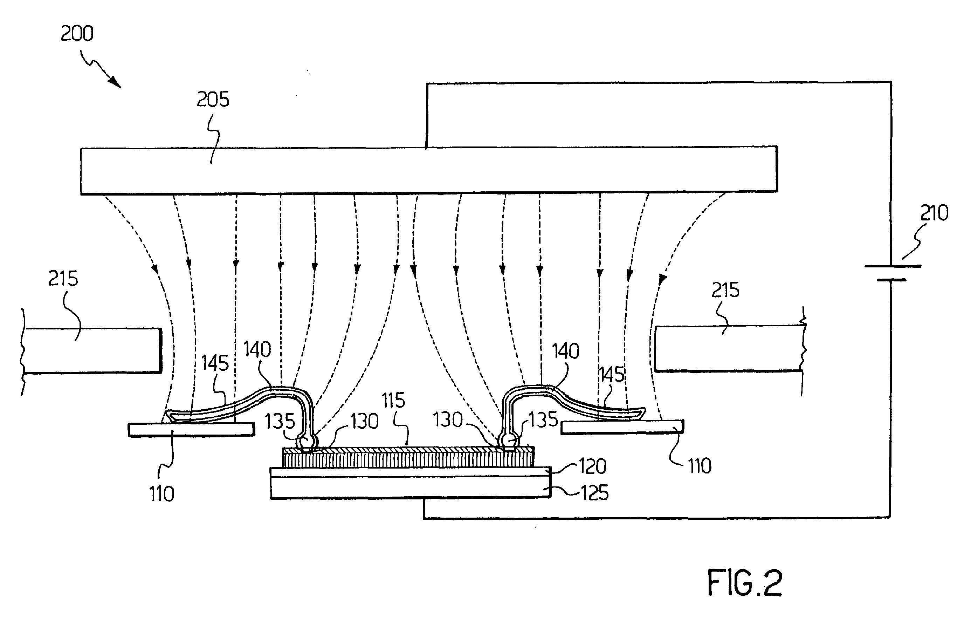

The layers of conducting material 145 are made by a process of electrodeposition. With reference to Fig. 2, the structure produced before the moulding process (lead frame 110, 120 with heat sinks 125, chips 115 and wires 140 connected between pads 130 and terminals 110) is appropriately prepared by a degreasing operation and a pickling operation, which makes it possible to remove any oxides by means of a corrosive solution (for example, sulphuric acid).

The structure 110-140 is then immersed in an electrolytic cell 200. In particular, a plurality of structures 110-140 are loaded on a rack which is immersed in the electrolytic cell 200, by a batch process, or are conveyed on belts (reel to reel) in a continuous process. In the electrolytic cell 200 there is a soluble positive electrode (anode) 205 (made from copper), connected to the positive terminal of a power source 210, whose negative terminal is connected to the structure 110-140, which therefore acts as a negative electrode (cathode). The structure 110-140 is covered with a mechanical mask 215 made from insulating material, for example polypropylene; the mask 215 protects the structure 110-140, leaving the wires 140 exposed.

The electrical field produced by the power source 210 causes an ionization of the soluble anode 205, with the formation of positive ions (cations) which are displaced towards the exposed areas of the cathode formed by the structure 110-140; these cations react, being reduced and deposited on the wires 140 (and on the bumps 135 and on the inner ends of the terminals 110), in such a way as to form the conducting layers 145. In general, the structure 110-140 is kept immersed in the electrolytic cell 200 for a few tens of minutes (with a current density of a few A/dm²) in the case of a batch process, or for a few minutes (with a current density of the order of 10-20 A/dm²) in the case of a continuous process.

In an alternative embodiment of the present invention, the layers of conducting material 145 are made by an electroless growing process. The structure 110-140 is covered selectively (in such a way as to leave the wires 140 exposed) with a layer of inhibitor material (for the reduction of the copper), such as benzotriazole (BTA). A plurality of structures 110-140 are loaded on a rack which is immersed in a bath containing a chemical copper-based autocatalytic solution; the chemical copper is deposited by catalytic action on the wires 140 (made from gold, for example), in such a way as to form the conducting layers 145. The process is then completed by the removal of the layer of inhibitor material in a bath containing sulphuric acid diluted to 2-3%.

Similar considerations are applicable in the case in which use is made of a different process of electrodeposition (with a non-soluble anode and a bath containing copper salts, for example), an electroless growing process using different materials, or other equivalent processes.

Clearly, the bonding method for an integrated circuit described above may be modified and varied in many ways by a person skilled in the art, in order to meet contingent and specific requirements, all such modifications and variations being moreover contained within the scope of protection of the invention, as defined by the following claims.

## Claims

1. Bonding method for an integrated circuit formed in a chip of semiconductor material (115) having a plurality of external electrical contacts (130), the method comprising the steps of
providing a plurality of terminals (110) for the electrical connection of the integrated circuit (115) to the exterior,
connecting each of a plurality of conducting wires (140) between a contact (130) and a corresponding terminal (110),
**characterized by** the step of
covering each conducting wire (140) resulting from said connecting step and connected between the contact (130) and the corresponding terminal (110) with a layer of conducting material (145) to produce an electrical connection between the contact (130) and the corresponding terminal (110) by the wire and the corresponding conducting layer (145)

2. Method according to Claim 1, in which each conducting wire (140) is made from a first material and each corresponding conducting layer (145) is made from a second material, the first and the second material being different from each other.

3. Method according to Claim 2, in which the second material is copper.

4. Method according to any of Claims 1 to 3, in which the integrated circuit is an integrated power circuit.

5. Method according to any one of Claims 1 to 4, additionally comprising the steps of:
providing a lead frame (110, 120) for a plurality of the said chips (115), the lead frame (110, 120) comprising, for each chip (115), a supporting pad (120) and the said terminals (110),
fixing each chip (115) on the corresponding pad (120).

6. Method according to any one of Claims 1 to 5, in which the step of covering each conducting wire (140) is carried out by a process of electrodeposition.

7. Method according to Claim 6, additionally comprising the steps of:
positioning an insulating mask (215) on the lead frame (110, 120), with the chips (115) fixed on the corresponding pads (120) and the conducting wires (140) connected to the contacts (130) and to the corresponding terminals (110), to leave the conducting wires (140) exposed,
immersing the lead frame (110, 120) in an electrolytic cell (200) comprising an anode (205),
connecting the anode (205) and the lead frame (110, 120), respectively, to a positive terminal and a negative terminal of a power source (210).

8. Method according to any one of Claims 1 to 5, in which the step of covering each conducting wire (140) is carried out by an electroless growing process.

9. Method according to Claim 8, further comprising the steps of:
selectively covering the lead frame (110, 120) with a layer of inhibitor material to leave the conducting wires (140) exposed,
immersing the lead frame (110, 120) covered with the inhibitor layer in an autocatalytic chemical solution,
removing the inhibitor layer.

## Patentansprüche

1. Bondverfahren für eine integrierte Schaltung, die in einem Chip aus einem Halbleitermaterial (115) gebildet ist, der eine Mehrzahl externer elektrischer Kontakte (130) aufweist, wobei das Verfahren folgende Schritte aufweist:
Bereitstellen einer Mehrzahl von Anschlüssen (110) für die elektrische Verbindung der integrierten Schaltung (115) mit dem Äußeren,
Schalten jedes einer Mehrzahl leitender Drähte (140) zwischen einen Kontakt (130) und einen entsprechenden Anschluss (110),
**gekennzeichnet durch** folgenden Schritt:
Bedecken jedes leitenden Drahts (140), der aus dem Verbindungsschritt resultiert und zwischen den Kontakt (130) und den entsprechenden Anschluss (110) geschaltet ist, mit einer Schicht aus einem leitenden Material (145), um eine elektrische Verbindung zwischen dem Kontakt (130) und dem entsprechenden Anschluss (110) durch den Draht und die entsprechende leitende Schicht (145) zu erzeugen.

2. Verfahren gemäß Anspruch 1, bei dem jeder leitende Draht (140) aus einem ersten Material hergestellt ist und jede entsprechende leitende Schicht (145) aus einem zweiten Material hergestellt ist, wobei sich das erste und das zweite Material voneinander unterscheiden.

3. Verfahren gemäß Anspruch 2, bei dem das zweite Material Kupfer ist.

4. Verfahren gemäß einem der Ansprüche 1 bis 3, bei dem die integrierte Schaltung eine integrierte Leistungsschaltung ist.

5. Verfahren gemäß einem der Ansprüche 1 bis 4, das zusätzlich folgende Schritte aufweist:
Bereitstellen eines Leiterrahmens (110, 120) für eine Mehrzahl der Chips (115), wobei der Leiterrahmen (110, 120) für jeden Chip (150) eine Trageanschlussfläche (120) und die Anschlüsse (110) aufweist,
Fixieren jedes Chips (115) auf der entsprechenden Anschlussfläche (120).

6. Verfahren gemäß einem der Ansprüche 1 bis 5, bei dem der Schritt des Bedeckens jedes leitenden Drahts (140) durch einen Vorgang einer Elektroaufbringung ausgeführt wird.

7. Verfahren gemäß Anspruch 6, das zusätzlich die folgenden Schritte aufweist:
Positionieren einer isolierenden Maske (215) auf dem Leiterrahmen (110, 120), wobei die Chips (115) auf den entsprechenden Anschlussflächen (120) fixiert sind und die leitenden Drähte (140) mit den Kontakten (130) und mit den entsprechenden Anschlüssen (110) verbunden sind, um die leitenden Drähte (140) freiliegend zu hinterlassen,
Versenken des Leiterrahmens (110, 120) in eine Elektrolysezelle (200), die eine Anode (205) aufweist,
Verbinden der Anode (205) und des Leiterrahmens (110, 120) mit einem positiven Anschluss bzw. einem negativen Anschluss einer Leistungsquelle (210).

8. Verfahren gemäß einem der Ansprüche 1 bis 5, bei dem der Schritt des Bedeckens jedes leitenden Drahts (140) durch einen stromlosen Aufwachsprozess ausgeführt wird.

9. Verfahren gemäß Anspruch 8, das ferner die folgenden Schritte aufweist:
selektives Bedecken des Leiterrahmens (110, 120) mit einer Schicht aus einem Inhibitormaterial, um die leitenden Drähte (140) freiliegend zu hinterlassen,
Versenken des Leiterrahmens (110, 120), der mit der Inhibitorschicht bedeckt ist, in eine autokatalytische chemische Lösung,
Entfernen der Inhibitorschicht.

## Revendications

1. Procédé de liaison destiné à un circuit intégré formé dans une puce de matériau semi-conducteur (115) ayant une pluralité de contacts électriques externes (130), le procédé comprenant les étapes consistant à :
- fournir une pluralité de terminaux (110) pour la connexion électrique à l'extérieur du circuit intégré (115);
- connecter chacun d'une pluralité de fils conducteurs (140) entre un contact (130) et un terminal correspondant (110) ;
**caractérisé par** l'étape consistant à recouvrir chaque fil conducteur (140), résultant de ladite étape de connexion et connecté entre le contact (130) et le terminal correspondant (110), d'une couche d'un matériau conducteur (145) de manière à produire une connexion électrique entre le contact (130) et le terminal correspondant (110) par le fil et la couche conductrice correspondante (145).

2. Procédé selon la revendication 1, dans lequel chaque fil conducteur (140) est fabriqué à partir d'un premier matériau et chaque couche conductrice (145) correspondante est fabriquée à partir d'un deuxième matériau, le premier et le deuxième matériaux étant différents l'un de l'autre.

3. Procédé selon la revendication 2, dans lequel le deuxième matériau est le cuivre.

4. Procédé selon l'une quelconque des revendications 1 à 3, dans lequel le circuit intégré est un circuit intégré de puissance.

5. Procédé selon l'une quelconque des revendications 1 à 4, comprenant en outre les étapes consistant à :
- fournir une grille de connexion (110, 120) pour une pluralité desdites puces (115), la grille de connexion (110, 120) comprenant, pour chaque puce (115), un plot de soutien (120) et lesdits terminaux (110) ; et
- fixer chaque puce (115) sur le plot correspondant (120).

6. Procédé selon l'une quelconque des revendications 1 à 5, dans lequel l'étape consistant à recouvrir chaque fil conducteur (140) est effectuée par un procédé d'électrodéposition.

7. Procédé selon la revendication 6, comprenant en outre les étapes consistant à :
- positionner un masque isolant (215) sur la grille de connexion (110, 120), les puces (115) étant fixées sur les plots correspondants (120) et les fils conducteurs (140) étant connectés aux contacts (130) et aux terminaux correspondants (110), de manière à laisser les fils conducteurs (140) exposés ;
- immerger la grille de connexion (110, 120) dans une cellule électrolytique (200) comprenant une anode (205) ; et
- connecter l'anode (205) et la grille de connexion (110, 120), respectivement, à un terminal positif et à un terminal négatif d'une source d'énergie (210).

8. Procédé selon l'une quelconque des revendications 1 à 5, dans lequel l'étape consistant à recouvrir chaque fil conducteur (140) est effectuée par un procédé de croissance autocatalytique.

9. Procédé selon la revendication 8, comprenant en outre les étapes consistant à :
- recouvrir sélectivement la grille de connexion (110, 120) d'une couche de matériau d'inhibiteur de manière à laisser les fils conducteurs (140) exposés ;
- immerger la grille de connexion (110, 120) recouverte de la couche d'inhibiteur dans une solution chimique autocatalytique ; et
- enlever la couche d'inhibiteur.
